# EUROPÄISCHE PATENTANMELDUNG

(11) **EP 0 658 076 A1**
(43) Veröffentlichungstag der Anmeldung: **14.06.1995**
(21) Anmeldenummer: 94112717.7
(22) Anmeldetag: 16.08.1994
(51) Int. Cl.: H05K 5/02, H05K 9/00

(54) **Gehäuse für Telekommunikationsanlagen in modularer Bauart**

(30) Priorität: 08.12.1993 DE 9319137 U
(71) Anmelder: DeTeWe - Deutsche Telephonwerke Aktiengesellschaft & Co., D-10997 Berlin (DE)
(72) Erfinder: Klingbeil, Manfred, D-12359 Berlin (DE); Krämer, Katharina, D-12047 Berlin (DE); Krispin, Harro, D-13503 Berlin (DE); Massmann, Manfred, D-12203 Berlin (DE); Pütz, Peter, D-12103 Berlin (DE); Schulz, Horst, D-12357 Berlin (DE); Wedell, Jürgen, D-10999 Berlin (DE)

(57) **Zusammenfassung**

Die Erfindung beschreibt ein Gehäuse für Telekommunikationsanlagen in modularer Bauart, dessen einzelnes Modul durch äußerlich gleiche Module zu leistungsfähigeren, größeren Anlagen erweiterbar ist. Das einzelne Modul besteht aus einer Bodenwanne (10) und einer Haube (20) mit Lüftungsschlitzen (21) für eine Wandmontage, wobei an der Bodenwanne (10) ein Baugruppenträger (30) befestigt ist, der mit einer Abdeckung (50) und in Verbindung mit der Bodenwanne (10) oder einer Blecheinlage der Bodenwanne (10) einen Faradayschen Käfig für aufzunehmende Steckbaugruppen (70) bildet. Eine Rückwand-Verdrahtungsplatte (40) ist auf Abstandssäulen (41) auf der Bodenwanne (10) befestigt. Die Steckverbinder liegen im Faradayschen Käfig des Baugruppenträgers (30) und tragen seitliche Steckverbinder unter Steckerschirmkappen (42) für die Verbindung zu den Bus-Systemen weiterer Module. Eine Stromversorgungseinheit (60) ist in der Bodenwanne (10) montiert, in dem sie mittels zweier Nasen (61) in zwei Konturen der Bodenwanne eingehängt und an der gegenüberliegenden Seite durch Verschraubung (62) gesichert wird.

## Beschreibung

Die Erfindung betrifft ein Gehäuse für Telekommunikationsanlagen in modularer Bauart, dessen einzelnes Modul durch äußerlich gleiche Module zu leistungsfähigeren, größeren Anlagen erweiterbar ist.

Modular aufgebaute Gehäuse für Telekommunikationsanlagen sind bekannt. Sie werden allgemein als Gestell-Schrankform ausgeführt, wobei Minderausbauten auch eine Minderung des mechanischen Aufwandes an den Baueinheiten bewirken und Erweiterungen durch Anreihen mehrerer gleicher Baueinheiten vorgenommen werden (DE 33 13 616 C2).

Moderne Telekommunikationsanlagen benötigen nicht mehr den mechanisch relativ großen Aufwand einer Gestell-Schrankform. Sie sind als Wandgehäuse ausgeführt, die eine geringe Wandfläche erfordern.

Der Erfindung lag die Aufgabe zugrunde, ein Konzept für einen modularen, erweiterungsfähigen Aufbau einer Telekommunikationsanlage für die Wandmontage zu schaffen.

Diese Aufgabe ist durch die Erfindung gelöst, wie sie im Kennzeichnungsteil des ersten Schutzanspruches dargelegt ist. Weitere vorteilhafte Maßnahmen sind Gegenstand der Unteransprüche.

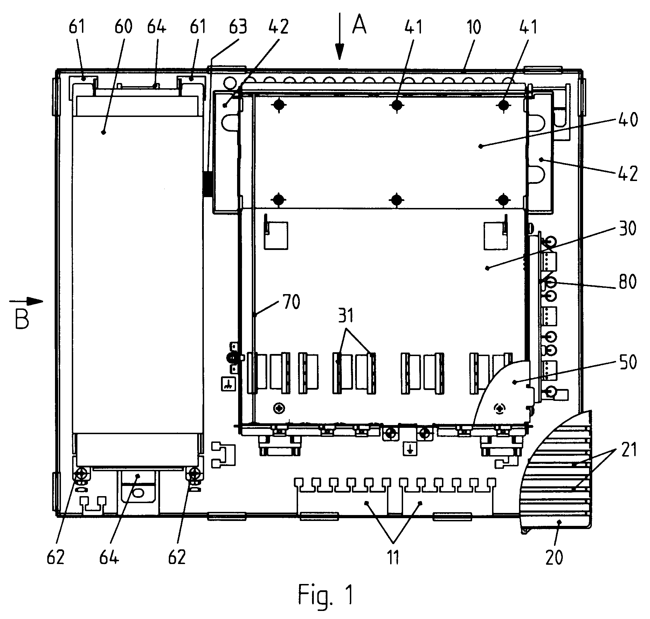

Die Erfindung wird nachfolgend anhand einer aus sechs Figuren bestehenden Zeichnung näher erläutert. Darin zeigen die
- Fig. 1: die Sicht auf ein geöffnetes Modul, die

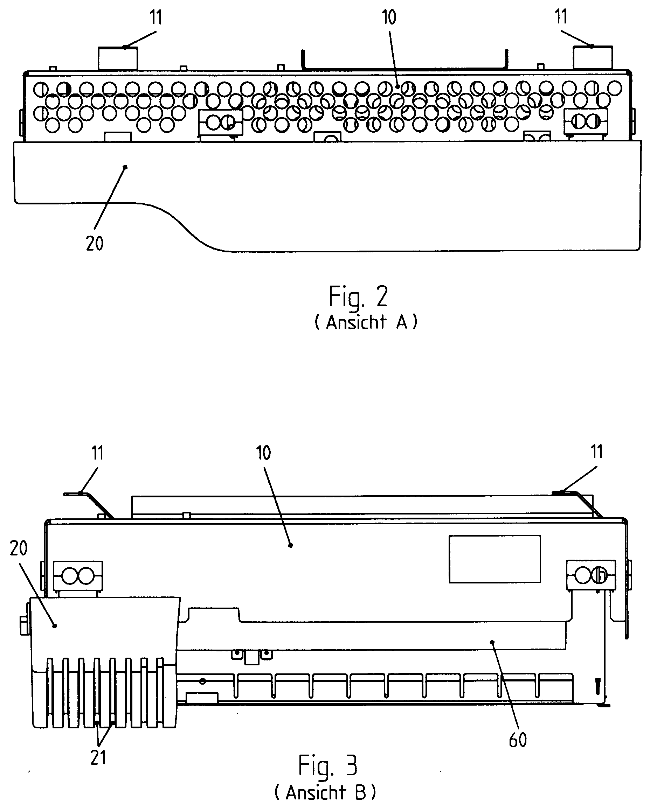

- Fig. 2: die Sicht auf die Oberseite (A) eines geschlossenen Moduls in Gebrauchslage, die
- Fig. 3: die Seitensicht (B) um 90^{o} gedreht bei nur teilweise dargestellter Haube, die
- Fig. 4: die Ansicht einer Steckbaugruppe, die
- Fig. 5: die perspektivische Darstellung eines bestückten Moduls ohne Haube und die
- Fig. 6: die Ansicht einer Telekommunikationsanlage, bestehend aus vier Modulen.

Das Gehäusesystem besteht aus einem Basismodul, dem Erweiterungsmodule für größere Ausbaustufen zugefügt werden. Das Basismodul weist eine Bodenwanne 10, eine Haube 20, einen Baugruppenträger 30, eine Rückwand-Verdrahtungsplatte 40, eine Baugruppenträger-Abdeckung 50 und eine Stromversorungseinheit 60 auf.

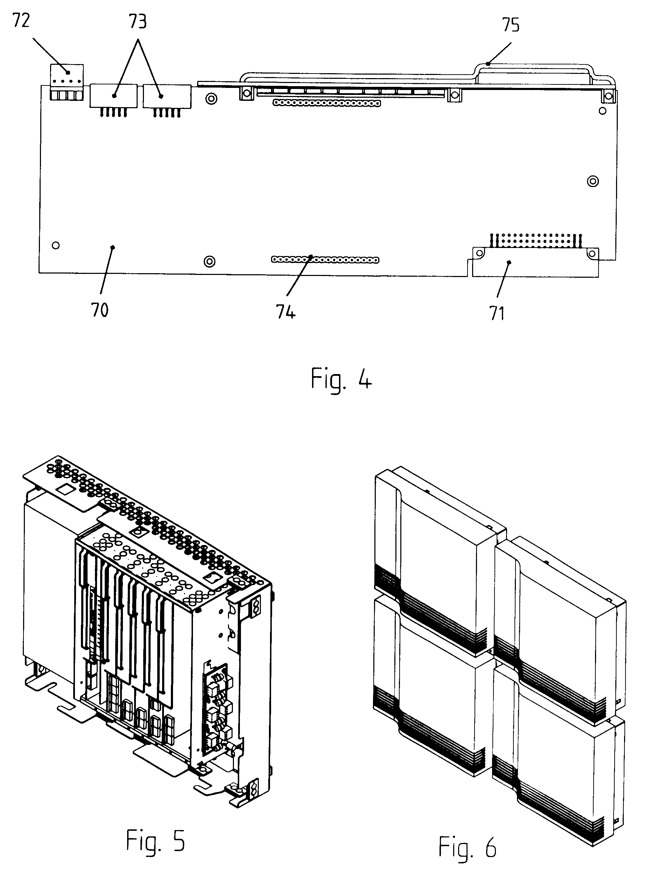

Die Erweiterungsmodule sind prinzipiell wie das Basismodul aufgebaut. Sie unterscheiden sich lediglich in der Bestückung durch die Steckbaugruppen im Baugruppenträger 30. Die Module werden übereinander und/oder nebeneinander angeordnet und durch Kabel untereinander verbunden (Fig. 6). Die Wandmontage des Gehäusesystems sieht vor, daß die Bodenwannen von Basis- und Erweiterungsmodulen an der Wand durch Verschraubung befestigt werden. Hierzu ist jede Bodenwanne 10 mit Befestigungslaschen 11 ausgestattet. Die Bodenwanne 10 ist als Blechteil oder als Kunststoffteil mit einer Blecheinlage für die Masseverbindungen zwischen Baugruppenträger 30 und Stromversorgungseinheit 60 ausgeführt. Der Baugruppenträger 30 bildet zusammen mit der Abdeckung 50 einen Faradayschen Käfig. An ihren in der montierten Stellung oberen Seiten sind die Bodenwanne 10 und der Baugruppenträger 30 gelocht, um eine entsprechende Wärmeabfuhr während des Betriebes zu gewährleisten. Gleiche Lochungen weist die Unterseite des Baugruppenträgers auf und die Haube 20 enthält in ihrem unteren Bereich Lüftungsschlitze 21. Bei montierter Haube 20 sorgt ein Abstand zwischen Haube 20 und Bodenwanne 10 für einen zusätzlichen Luftein- und -austritt. Je Anlagenmodul ist eine Stromversorgungseinheit 60 vorhanden. Als Berührungsschutz ist eine Blechklappe auf die Stromversorgungseinheit 60 gesetzt. Die Stromversorgungseinheit 60 wird mittels zweier Nasen 61 in zwei Konturen der Bodenwanne 10 eingehängt und an der gegenüberliegenden Seite in ihrer Auflage fixiert und durch Verschraubung 62 gesichert. Sie ist auf einen Trägerwinkel 64 montiert, so daß eine Zweilagen-Leiterplatte Verwendung findet. Die Stromversorgungseinheit 60 erzeugt die benötigten Spannungen, die über ein Flachbandkabel 63 mit Steckverbindern an die Rückwand-Verdrahtungsplatte 40 geführt werden. Zwei nebeneinanderliegende Primäranschlüsse dienen der Netzspannungszufuhr und deren Durchschleifen zu Erweiterungsmodulen.

Die Bodenwanne 10 trägt die auf mehreren Abstandssäulen 41 angeordnete Rückwand-Verdrahtungsplatte 40. Diese Rückwand-Verdrahtungsplatte 40 ist eine Zweilagen-Leiterplatte, die über zwei Bus-Systeme die Verbindungen der Nutz- und Steuerkanäle herstellt. Die Bus-Systeme werden mittels Steckverbindungen an die Steckbaugruppen 70 geführt. Seitlich ist die Rückwand-Verdrahtungsplatte 40 mit Bus-Anschlußsteckverbindern versehen, die durch Steckerschirmkappen 42 abgedeckt sind. Über diese Anschlüsse werden die Bus-Systeme mehrerer Module untereinander gekoppelt.

Für einen vielfältigen Einsatz der Telekommunikationsanlagen sind mehrere Steuerbaugruppen und Peripheriebaugruppen vorgesehen, die unterschiedliche Steuerungen, analoge und digitale Anschaltungen sowie Zusatz- und Mischfunktionen gestatten. Diese Baugruppen sind auf Steckbaugruppen 70 mit einheitlichen Leiterplattenabmessungen in Zweilagen-Ausführungen angeordnet. Ein z. B. 48-poliger Stiftsteckverbinder 71 am Baugruppenrand (Fig. 4) stellt die Verbindung zur Rückwand-Verdrahtungsplatte 40 her, wobei der Stiftsteckverbinder 71 mit voreilenden Stiften versehen ist. Entsprechend sind die Kontaktsteckverbinder der Rückwand-Verdrahtungsplatte 40 mit voreilenden Kontakten ausgestattet, so daß eine Führung und eine Masseverbindung vor dem betriebsmäßigen Anschluß der Steckbaugruppe 70 gewährleistet ist.

Auf dem dem Stiftsteckverbinder 71 gegenüberliegenden Rand der Steckbaugruppe 70 ist jeweils ein Übergabeverbinder 72 vorgesehen. Die Steckbaugruppen 70, die die Zentralsteuerung aufnehmen und weitere Applikationsbaugruppen weisen zusätzliche Übergabesteckverbinder 73 für V-24-Schnittstellen auf. Stecker 74 gestatten den Anschluß von Unterbaugruppen auf den Steckbaugruppen 70. Die Steckerbaugruppen 70 sind mit Kunststoffgriffleisten 75 versehen. Die Griffleisten 75 sind elastische ausgebildet. Diese Maßnahme gestattet durch entsprechende Konturen in der Abdeckung 50 das Fixieren der Steckbaugruppen 70 während des Transportes. Die im Baugruppenträger 30 zugewandten Kanten der Steckbaugruppen 70 werden zusätzlich durch Massekontaktfedern 31 positioniert.

Am Baugruppenträger 30 kann seitlich bei Bedarf eine Baugruppe für den Überspannungsschutz 80 montiert werden.

In der Fig. 5 ist ein maximal mit Steckbaugruppen 70 bestückter Modul perspektivisch gezeigt, wobei die Haube 20 und die Abdeckung 50 fortgelassen wurden.

Eine aus vier Modulen bestehende Telekommunikationsanlage ist in der Fig. 6 dargestellt. Die Kabelanschlüsse der Endgeräte, der Stromversorgung und des Kommunikationsnetzes werden an der Unterseite der Module eingeführt, wobei vorzugsweise Steckverbindungen in den Öffnungen 11 der Bodenwanne 10 angebracht sind. Die Module untereinander werden über geschirmte Schnüre und Kabelauslässe im Bereich unterhalb der Rückwand-Verdrahtungsplatten 40 verbunden.

## Patentansprüche

1. Gehäuse für Telekommunikationsanlagen in modularer Bauart, dessen einzelnes Modul durch äußerlich gleiche Module zu leistungsfähigeren, größeren Anlagen erweiterbar ist, dadurch gekennzeichnet,
daß das einzelne Modul aus einer Bodenwanne (10) und einer Haube (20) mit Lüftungsschlitzen (21) ausschließlich für eine Wandmontage besteht,
daß an der Bodenwanne (10) ein Baugruppenträger (30) befestigt ist, der mit einer Abdeckung (50) und in Verbindung mit der Bodenwanne (10) oder einer Blecheinlage der Bodenwanne (10) einen Faradayschen Käfig für aufzunehmende Steckbaugruppen (70) bildet,
daß eine Rückwand-Verdrahtungsplatte (40) auf Abstandssäulen (41) auf der Bodenwanne (10) befestigt ist, deren Steckverbinder im Faradayschen Käfig des Baugruppenträgers (30) liegen und die seitliche Steckverbinder unter Steckerschirmkappen (42) für die Verbindung zu den Bus-Systemen weiterer Module tragen und
daß eine Stromversorgungseinheit (60) in der Bodenwanne (10) montiert ist, in dem diese mittels zweier Nasen (61) in zwei Konturen der Bodenwanne eingehängt und an der gegenüberliegenden Seite durch Verschraubung (62) gesichert wird.

2. Gehäuse nach Anspruch 1, dadurch gekennzeichnet, daß die Bodenwanne (10) und der Baugruppenträger (30) Lochungen für eine Wärmeabfuhr aufweisen.

3. Gehäuse nach Anspruch 1, dadurch gekennzeichnet, daß die Steckbaugruppen (70) Leiterplatten in Zweilagen-Ausführungen mit einheitlichen Abmessungen sind.

4. Gehäuse nach Anspruch 1 und 3, dadurch gekennzeichnet, daß die Steckbaugruppen (70) und die Rückwand-Verdrahtungsplatte (40) Stiftsteckverbinder (71) bzw. Kontaktsteckverbinder mit voreilenden Kontakten aufweisen.

5. Gehäuse nach Anspruch 1, 3 und 4, dadurch gekennzeichnet, daß die Steckbaugruppen (70) durch Massekontaktfedern (31) des Bodenbleches des Baugruppenträgers (30) in ihrer Lage fixiert werden.

6. Gehäuse nach Anspruch 1, und 3 bis 5, dadurch gekennzeichnet, daß die Steckbaugruppen (70) elastisch ausgebildete Griffleisten (75) aufweisen, die eine Lagefixierung durch Konturen in der Abdeckung (50) gestatten.
